# EUROPÄISCHE PATENTSCHRIFT

(11) **EP 2 191 703 B1**
(45) Veröffentlichungstag und Bekanntmachung des Hinweises auf die Patenterteilung: **24.09.2014**
(21) Anmeldenummer: 08785945.0
(22) Anmeldetag: 07.07.2008
(51) Int. Cl.: H05K 5/00, H05K 7/14

(54) **GEHÄUSE FÜR EINE ELEKTRISCHE SCHALTUNG, INSBESONDERE EINES STEUERGERÄTS EINES FAHRZEUGS**
HOUSING FOR AN ELECTRIC CIRCUIT, PARTICULARLY A CONTROL DEVICE OF A VEHICLE
BOÎTIER POUR UN CIRCUIT ÉLECTRIQUE, NOTAMMENT D'UN APPAREIL DE COMMANDE D'UN VÉHICULE

(30) Priorität: 16.08.2007 DE 102007038538
(43) Veröffentlichungstag der Anmeldung: 02.06.2010
(73) Patentinhaber: Robert Bosch GmbH, 70442 Stuttgart (DE)
(72) Erfinder: ILIC, Erich, 72805 Unterhausen (DE); HEIM, Michael, 71088 Holzgerlingen (DE); RAICA, Thomas, 72379 Hechingen (DE)
(86) Internationale Anmeldenummer: PCT/EP2008/058761
(87) Internationale Veröffentlichungsnummer: WO 2009/021777

(56) Entgegenhaltungen:
- WO-A-01/84898
- DE-A1- 10 315 299
- DE-U1- 29 603 390
- US-A1- 2005 135 073

## Beschreibung

Die Erfindung betrifft ein Gehäuse für eine elektrische Schaltung, insbesondere eines Steuergeräts eines Fahrzeugs, insbesondere eines Kraftfahrzeugs, mit einem Boden, einem Deckel und einer elektrischen Anschlussschnittstelle.

### Stand der Technik

Gehäuse für elektrische Schaltungen, insbesondere für Steuergeräte von Fahrzeugen, sind bekannt. Sie dienen der Aufnahme von elektrischen Schaltungen und zu deren Abschirmung von unerwünschten Umwelteinflüssen. Sie dienen weiterhin der vereinfachten und gegenüber dem Fahrzeug isolierten Anordnung der elektrischen Schaltung beispielsweise im Motorraum von Fahrzeugen. Als elektrische Schaltungen kommen insbesondere Steuergeräte in Leiterplattentechnik in Betracht. Gehäuse für derartige Steuergeräte in Leiterplattentechnik werden im Stand der Technik üblicherweise aus den Komponenten Boden, Deckel, Schaltungsträger und Anschlussschnittstelle (Stecker beziehungsweise Steckergehäuse) aufgebaut. Boden und Deckel solcher Gehäuse werden meist über Schrauben verbunden, wobei die Dichtheit des Steuergerätes durch kompliziert geformte, dreidimensionale Dichtkonturen aufweisende Dichtungen bewirkt wird. Der mechanische Aufbau dieser Gehäuse ist vielteilig und relativ kompliziert, insbesondere auch der Anschluss der als Anschlussschnittstelle verwendeten Messerleiste, die einerseits, gehäuseinnenseitig, in die Leiterplatte gesteckt und mit dieser verlötet wird und im Übrigen einen Durchgriff des Steckergehäuses durch das Gehäuse selbst aufweist, der seinerseits abzudichten ist. Hieran ist nachteilig, dass über das separate Steckergehäuse und dessen direkte Verlötung in der Leiterplatte relativ starke Kräfte auf die Leiterplatte übertragen werden können, was zu unerwünschten Beeinträchtigungen der dortigen Lötkontaktierungen führen kann. Im Übrigen werden zwei Schnittstellen ausgebildet, nämlich einmal die Messerleiste hin zum Kabelbaumstecker, und zum Anderen die das Steckergehäuse durchgreifende Messerleiste zur Leiterplatte. Derart komplizierte Gehäuse sind nicht nur hinsichtlich ihrer Bauteile aufwendig, sondern insbesondere auch in der Fertigung entsprechend teuer.

Ein solches Gehäuse ist aus dem Dokument DE29603390U1 bekannt.

### Offenbarung der Erfindung

Aufgabe der Erfindung ist es, ein Gehäuse für eine elektrische Schaltung der gattungsgemäßen Art bereitzustellen, das die genannten Nachteile vermeidet, indem es bei reduzierter Gehäusezahl einen kostengünstigeren, vereinfachten Aufbau und eine Reduktion der effektiv wirksamen Schnittstellen aufweist.

Es wird hierzu ein Gehäuse für eine elektrische Schaltung, insbesondere eines Steuergeräts eines Fahrzeugs, insbesondere Kraftfahrzeugs, mit einem Boden, einem Deckel und einer elektrischen Anschlussschnittstelle vorgeschlagen. Es ist vorgesehen, dass der Boden als Bodenschale und dass der Deckel als Deckelschale ausgebildet sind, wobei der Boden und/oder der Deckel eine integrierte Schaltungsträgeraufnahme für einen elektrischen Schaltungsträger aufweist und dass der Boden und/oder der Deckel mindestens einen Durchbruch für die als lösbare Anschlussschnittstelle ausgebildete Anschlussschnittstelle aufweist. Anders als im Stand der Technik ist das Gehäuse hierbei nur noch zweiteilig, nämlich bestehend aus einer Bodenschale und einer Deckelschale. Entweder der Boden, der Deckel oder beide weisen hierbei eine integrierte Schaltungsträgeraufnahme auf, die den elektrischen Schaltungsträger (im Regelfall eine bestückte Leiterplatte) aufnimmt. Eine Befestigung des Schaltungsträgers über separate, ihn haltende Bauteile entfällt hierbei. Weiter weist der Boden und/oder der Deckel mindestens einen Durchbruch für die Anschlussschnittstelle auf, die als lösbare Anschlussschnittstelle ausgebildet ist. Im Stand der Technik ist die Anschlussschnittstelle über ein in das Gehäuse eingebautes Steckergehäuse, das eine auf die Leiterplatte kontaktierte Messerleiste aufweist, gebildet. Dieses separate Steckergehäuse ist erfindungsgemäß verzichtbar. Die Anschlussschnittstelle ist hierbei als lösbare Anschlussschnittstelle ausgebildet, also so, dass sie, im Gegensatz zum Stand der Technik, verbindbar, aber nicht dauerverbunden ausgestaltet ist.

In einer weiteren Ausführungsform ist der Durchbruch in einer Deckenwandung der Deckelschale und/oder in einer Bodenwandung der Bodenschale angeordnet. Hiermit ist gemeint, dass der Durchbruch in der jeweils im Wesentlichen flächig ausgebildeten Deckenwandung oder Bodenwandung ausgebildet ist, also so, dass sich ein gut zugänglicher Durchtritt ober- oder unterhalb der elektrischen Schaltung erzielen lässt.

In einer bevorzugten Ausführungsform ist der Durchbruch von einem Stehkragen berandet. Der Stehkragen dient hierbei der Abstützung von mit der Anschlussschnittstelle zusammenwirkenden Schnittstellenverbindungselementen, wie sie beispielsweise an einem Kabelbaum zur Kontaktierung des im Gehäuse befindlichen Steuergeräts angeordnet sind. Der Stehkragen dient weiter der mechanischen Stabilisierung der Deckelschale und/oder Bodenschale, in deren Deckenwandung und/oder Bodenwandung der Durchbruch angeordnet ist. Es wird hierbei eine Durchbiegung der Deckenwandung oder Bodenwandung, insbesondere unter Belastung durch einen aufgesteckten Kabelbaum, deutlich reduziert.

In einer weiteren Ausführungsform weist die Anschlussschnittstelle elektrische Steckaufnahmen auf, insbesondere nämlich elektrische Buchsenelemente, in die Steckstifte eines Anschlusssteckers einsteckbar sind. Im Gegensatz zum Stand der Technik befinden sich die Steckstifte in dieser Ausführungsform an einem Anschlussstecker, der den Durchbruch durchgreift. Im Stand der Technik hingegen befinden sich Steckstifte als Messerleiste ausgebildet in dem mit dem Gehäuse verbundenen Steckergehäuse.

In einer bevorzugten Ausführungsform sind die elektrischen Steckaufnahmen an dem Schaltungsträger angeordnet oder dort ausgebildet. Die Steckaufnahmen, die der Aufnahme der Steckstifte des Anschlusssteckers zur Ausbildung einer elektrischen Kontaktierung dienen, sind demzufolge an dem Schaltungsträger (also im weitesten Sinne der Platine) angeordnet oder dort ausgebildet, beispielsweise in Form von auf den Schaltungsträger aufgelöteten Steckaufnahmeelementen. Bevorzugt sind diese auf der Seite des Schaltungsträgers ausgebildet, die dem Durchbruch unmittelbar gegenüberliegt, von dem Anschlussstecker folglich direkt beaufschlagt werden kann.

In einer besonders bevorzugten Ausführungsform weisen die elektrischen Steckaufnahmen Anschlussdurchbrüche in dem Schaltungsträger auf. Hiermit ist gemeint, dass Anschlussdurchbrüche in dem Schaltungsträger derart eingebracht sind, dass die Steckstifte den Schaltungsträger durchgreifen. Diese lassen sich beispielsweise als Bohrungen in der Platine ausbilden, wobei Kontaktelemente, beispielsweise Federbuchsen, in diese Bohrungen eingebracht werden, und wobei die Steckstifte des Anschlusssteckers in diese Federbuchsen eingreifen, und zwar über die Ebene der Platine hinaus (also an deren anderer Seite austretend). Hierdurch lässt sich eine sehr sichere und stromtragfähige Kontaktierung bewirken.

In einer weiteren Ausführungsform weisen die Deckelschale und/oder die Bodenschale Kühlkontaktflächen zum Berührungskontaktieren von dem Schaltungsträger zugeordneten elektrischen/elektronischen Bauteilen auf. Elektrische/elektronische Bauteile können im Betrieb eine erhebliche Verlustabwärme erzeugen, die durch geeignete Maßnahmen abgeführt werden muss, um eine unerwünschte Beeinträchtigung des Bauteils zu vermeiden. Hierzu weisen die Deckelschale und/oder die Bodenschale Kühlkontaktflächen auf, die derart ausgestaltet sind, dass sie das Berührungskontaktieren der zu kühlenden Bauteile zulassen. Im einfachsten Falle sind die Kühlkontaktflächen als dem Schaltungsträger zugewandten Erhebungen im oder aus dem Material der Deckelschale oder der Bodenschale ausgebildet, wobei diese Erhebungen eine solche Dimension aufweisen, dass die ihnen jeweils zugewandte Seite des zu kühlenden Bauteils sicher berührungskontaktiert werden kann. Gleichwohl ist die Überbrückung von möglichen, auch fertigungstechnisch bedingten Spalten und Freiräumen zwischen Bauteil und Berührungskontaktfläche durch Einbringung beispielsweise von Wärmeleitkleber möglich. Auf diese Weise lässt sich der Einsatz von gesonderten Kühlkörpern, die beispielsweise wie im Stand der Technik auf die Bauteile montiert werden müssen, vermeiden, und gleichzeitig eine sehr gute Wärmeabfuhr durch die Deckelschale und/oder die Bodenschale an die Umwelt bewirken.

In einer weiteren Ausführungsform ist die Deckelschale und/oder die Bodenschale mit mindestens einem integrierten Schaltungsträgerniederhalter ausgebildet. Ein Schaltungsträgerniederhalter ist hierbei ein solcher Niederhalter, der den Schaltungsträger an mindestens einem Punkt beaufschlagt, so dass dieser sich, an seiner gegenüberliegenden Seite an einem anderen Teil, beispielsweise der gegenüberliegenden Schale, abstützt und hierdurch in seiner Einbauendlage gehalten wird. Bevorzugt liegen sich Schaltungsträgerniederhalter sowohl an Deckelschale als auch an Bodenschale gegenüber, wobei der Schaltungsträger zwischen den Schaltungsträgerniederhaltern geklemmt, nämlich beidseitig kraftbeaufschlagt wird.

In einer weiteren Ausführungsform weisen Deckelschale und Bodenschale miteinander verrastbare Rastelemente auf. Diese Rastelemente bewirken ein Zusammenhalten von Deckenschale und Bodenschale, beispielsweise dadurch, dass die Rastelemente einerseits als Rasthaken, beispielsweise an der Deckelschale, und an der Bodenschale als eine mit der Rastnase zusammenwirkende Rastleiste ausgebildet sind. Die Rastleiste kann hierbei nur bereichsweise an den Seiten des Gehäuses ausgebildet sein oder auch umlaufend; Rastnasen werden vorzugsweise (wobei aber auch andere Ausführungen möglich sind) abschnittsweise ausgebildet.

In einer anderen Ausführungsform weisen Deckelschale und Bodenschale Klemmflächen für dem Verklemmen der beiden Schalen dienende Federelemente auf. Die Klemmflächen werden hierbei abschnittsweise oder umlaufend sowohl an Deckelschale als auch an Bodenschale, bevorzugt an der äußersten Außenkontur, ausgebildet und weisen hierbei Abstützflächen auf, die dem Aufbringen von Federelementen, beispielsweise von Federbügeln dienen, die die Auflageflächen mit Federkraft beaufschlagen und somit Deckelschale und Bodenschale durch Zusammenpressen aufeinander halten.

In einer bevorzugten Ausführungsform ist zwischen Deckelschale und Bodenschale mindestens eine Dichtung angeordnet, bevorzugt als umlaufende Dichtung, besonders bevorzugt als dispenste Nassdichtung, wobei aber auch eine Festkörperdichtung möglich ist.

In einer anderen Ausführungsform ist dem Durchbruch eine Abdichtung zugeordnet. Dies bedeutet, dass der Durchbruch, beispielsweise außenseitig des Stehkragens, eine Dichtung, beispielsweise eine Festkörperdichtung mit umlaufenden, mehrfach angeordneten Dichtlippen, aufweist. Hierdurch lässt sich bei einem den Stehkragen übergreifenden, etwa eine Tülle aufweisenden Anschlussstecker eine einfache und wirksame, dabei kostengünstige Abdichtung erreichen.

### Kurze Beschreibung der Zeichnungen

Im Folgenden soll die Erfindung anhand von Zeichnungen näher erläutert werden. Es zeigen
- Figur 1: ein Gehäuse für eine elektrische Schaltung mit eingesetztem Anschlussstecker;
- Figur 2: eine integrierte Schaltungsträgeraufnahme und einen Schaltungsträgerniederhalter;
- Figur 3: im Querschnitt eines Gehäusedetails eine zwischen den Gehäuseschalen eingebrachte, umlaufende Dichtung;
- Figur 4: an Deckelschale und Bodenschale ausgebildete, miteinander verrastbare Rastelemente;
- Figur 5: an Deckelschale und Bodenschale ausgebildete Klemmflächen für Federelemente zum Verklemmen der beiden Schalen und
- Figur 6: eine ausschnittsweise Darstellung des Anschlusssteckers mit einem den Stehkragen übergreifenden Wulst sowie einer zwischen Anschlussstecker und Stehkragen eingebrachten, umlaufenden Lamellendichtung.

### Ausführungsform(en) der Erfindung

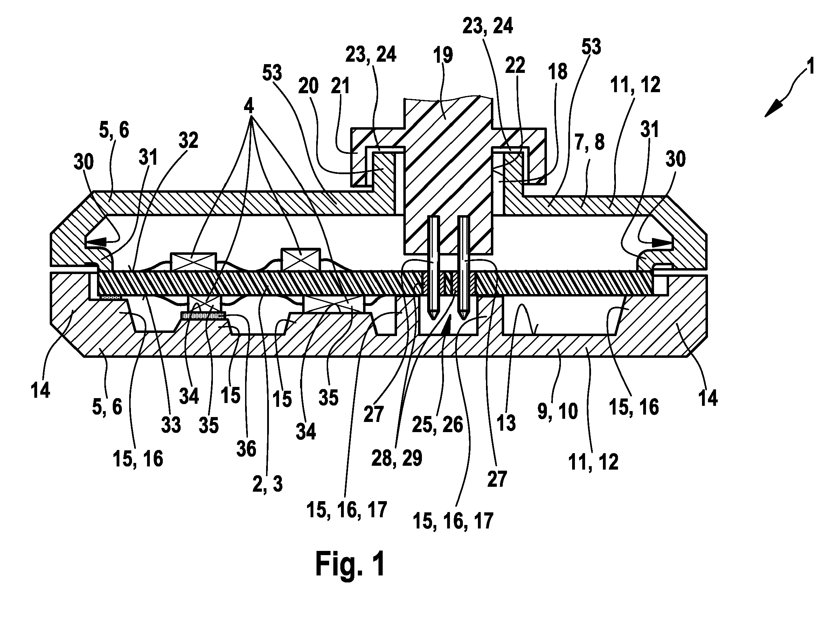

Figur 1 zeigt ein Gehäuse 1 für eine auf einem Schaltungsträger 2, nämlich einer Platine 3 angeordnete, nur symbolisch dargestellte elektronische oder elektrische Schaltung 4. Das Gehäuse 1 besteht aus zwei Schalen 5, nämlich Gehäuseschalen 6. Diese sind als einen Deckel 7 bildende Deckelschale 8 und eine einen Boden 9 bildenden Bodenschale 10 ausgebildet. Die Schalen 5 bestehen hierbei beispielsweise aus einem Leichtmetall 11, beispielsweise aus einer Aluminiumdruckgusslegierung 12. Der Boden 9 weist auf einer Bodeninnenseite 13 in einem Bodenrandwandbereich 14 als über die Bodenseite 13 gehäuseinnenseitig erhabene Erhebungen 15 ausgebildete Schaltungsträgeraufnahmen 16 auf. Ebenso befinden sich Schaltungsträgeraufnahmen 16, die ebenfalls als Erhebungen 15 über der Bodeninnenseite 13 ausgebildet sind, in einem Bereich innen abseits der Bodenwandrandbereiche 14; diese sind als Abstützauflagen 17 ausgebildet. Auf den Schaltungsträgeraufnahmen 16 aufgelegt ist der Schaltungsträger 2, der die elektrische Schaltung 4 trägt. Der Deckel 7 weist in seiner Deckenwandung einen Durchbruch 18 zum Durchtritt eines Anschlusssteckers 19 auf, wobei der Durchbruch 18 von einem den Deckel 7 nach außen hin überragenden Stehkragen 20 berandet ist. Der Anschlussstecker 19 weist eine den Stehkragen 20 übergreifende Tülle 21 auf, die zusammen mit einer innenseitig der Tülle 21 gelegenen Anschlusssteckeraußenfläche 22 eine Labyrinthdichtung 23 ausbildet, die als Abdichtung 24 dem Durchbruch 18 bei eingestecktem Anschlussstecker 19 zugeordnet ist. Der Anschlussstecker 19 dient zur elektrischen Kontaktierung der elektrischen Schaltung 4 auf dem Schaltungsträger 2 über eine Anschlussschnittstelle 25. Die Anschlussschnittstelle 25 ist als lösbare Anschlussschnittstelle 26 ausgebildet, was bedeutet, dass die elektrische Verbindung respektive der Anschluss als solcher hergestellt oder auch gelöst beziehungsweise geöffnet werden kann. Das Lösen der Anschlussschnittstelle 25 geschieht durch Abziehen des Anschlusssteckers 19, wobei sich in diesen integrierte Steckstifte 27 aus einer diesen jeweils zugeordneten Steckaufnahme 28 lösen, die in den Schaltungsträger 2, nämlich die Platine 3 derart integriert ist, dass die Steckstifte im geschlossenen Zustand der Anschlussschnittstelle 25, also bei eingestecktem Anschlussstecker 19, Anschlussdurchbrüche 29 in dem Schaltungsträger 2 durchgreifen, also unterseitig des Schaltungsträgers 2, auf der dem Anschlussstecker 19 abgewandten Seite des Schaltungsträgers 2, wieder austreten. Die Anschlussdurchbrüche 29 können hierbei beispielsweise als in Bohrungen in der Platine 3 eingelassene Federbuchsen ausgebildet sein, die mit hier nicht dargestellten Leiterbahnen der elektrischen Schaltung 4 beispielsweise verlötet oder in sonst geeigneter Weise kontaktiert sind. Der Deckel 5 weist weiter an Deckelwandrandbereichen 30 Schaltungsträgerniederhalter 31 auf, die sich auf einer Schaltungsträgeroberseite 32 abstützen, während eine Schaltungsträgerunterseite 33 des Schaltungsträgers 2 auf den Schaltungsträgeraufnahmen 16 aufliegt. Auf diese Weise wird eine definierte Auflage und Halterung des Schaltungsträgers 2 im Gehäuse 1 erreicht. Die Abstützauflagen 17, die als Schaltungsträgeraufnahmen 16 an dem Boden 9 innenseitig ausgebildet sind, dienen ferner durch ihre unmittelbare Nachbarschaft zu den Steckaufnahmen 28, nämlich den Anschlussdurchbrüchen 29, als Abstützungen beim Einstecken des Anschlusssteckers 19 in die Steckaufnahmen 28, dadurch, dass sie die hierbei auf den Schaltungsträger 2 einwirkenden Kräfte durch Abstützen des Schaltungsträgers 2 aufnehmen.

Der Boden 7 weist weiter als Erhebungen 15 ausgebildete Kühlkontaktflächen 34 auf, die mit zu kühlenden Bauteilen 35 der elektrischen Schaltung 4 in Berührungskontakt treten und Abwärme der zu kühlenden Bauteile 35 an die Umgebung ableiten. Zwischen den zu kühlenden Bauteilen 35 und den Kühlkontaktflächen 34 kann bedarfsweise eine Schicht Wärmeleitpaste 36 oder ein wärmeleitender Kleber eingebracht werden, der nicht nur der guten Wärmeableitung vom zu kühlenden Bauteil 35 über den Boden 9 führt, sondern auch fertigungsbedingte Toleranzen, insbesondere sich bei Einlage des Schaltungsträgers 2 auf die Schaltungsträgeraufnahmen 16 ergebende möglichen Spalte überbrückt.

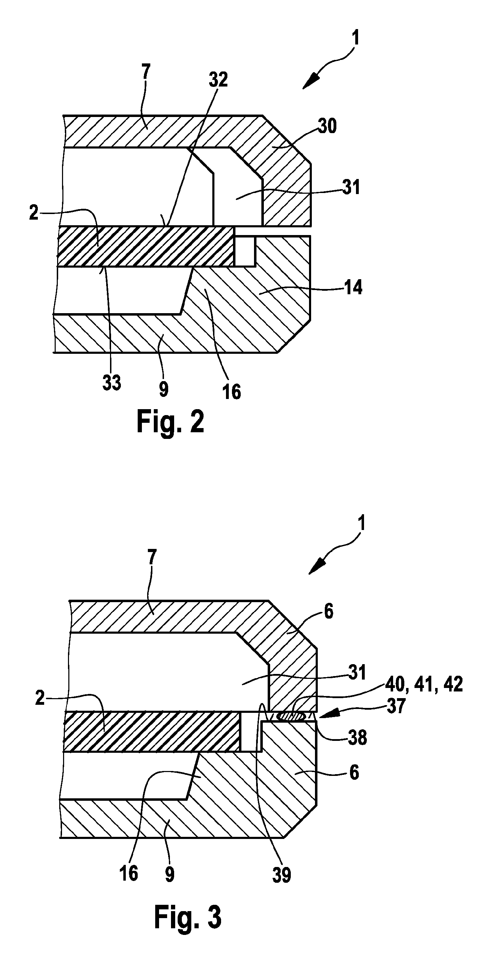

Figur 2 zeigt in Detaildarstellung einen Abschnitt des Gehäuses 1 im Längsschnitt mit dem Deckel 7 und dem Boden 9, wobei der Boden 9 im Bodenwandrandbereich 14 die Schaltungsträgeraufnahme 16 zur Aufnahme des Schaltungsträgers 2 aufweist. Der Schaltungsträger 2 stützt sich hierbei mit seiner Schaltungsträgerunterseite 33 auf der Schaltungsträgeraufnahme 16 ab, während er auf seiner Schaltungsträgeroberseite 32 durch eine im Deckelwandrandbereich 30 innenseitig des Gehäuses in Gegenüberlage der Schaltungsträgeraufnahme 16 angeordneten Schaltungsträgerniederhalter 31 beaufschlagt wird. Bei geschlossenem Gehäuse 1 ergibt sich hierdurch eine randseitige Klemmung des Schaltungsträgers 2 und damit eine eindeutige, sichere Lagefixierung des Schaltungsträgers 2.

Figur 3 zeigt einen Abschnitt des Gehäuses 1 mit dem Deckel 7 und dem Boden 9 sowie einem auf dem Boden 9 zugeordneten Schaltungsträgeraufnahme 16 aufgelegten Schaltungsträger 2. In einem randseitigen Fügebereich 37 der Gehäuseschalen 6, nämlich des Deckels 7 und des Bodens 9, ist zwischen einer Deckelwandstirnfläche 38 und einer Bodenwandstirnfläche 39 eine Dichtung 40 eingebracht, die als umlaufende Dichtung 41, bevorzugt als Nassdichtung 42 ausgebildet ist. Als Nassdichtung 42 kommt insbesondere eine dispenste Dichtung in Betracht, also eine solche, die auf die Bodenwandstirnfläche und/oder die Deckelwandstirnfläche aufgebracht wird, bevor die Gehäuseschalen 6 im Fügebereich 37 aufeinander gefügt werden. Selbstverständlich sind auch Ausführungen mit einer Festkörperdichtung denkbar, wobei diese beispielsweise in hier nicht dargestellte, umlaufende Vertiefungen in der Deckelwandstirnfläche 38 und/oder der Bodenwandstirnfläche 39 derart eingelegt wird, dass sie beim Zusammenfügen der Gehäuseschalen 6 in diesen vollständig und unter Spannung anliegt und so sicher abdichtet.

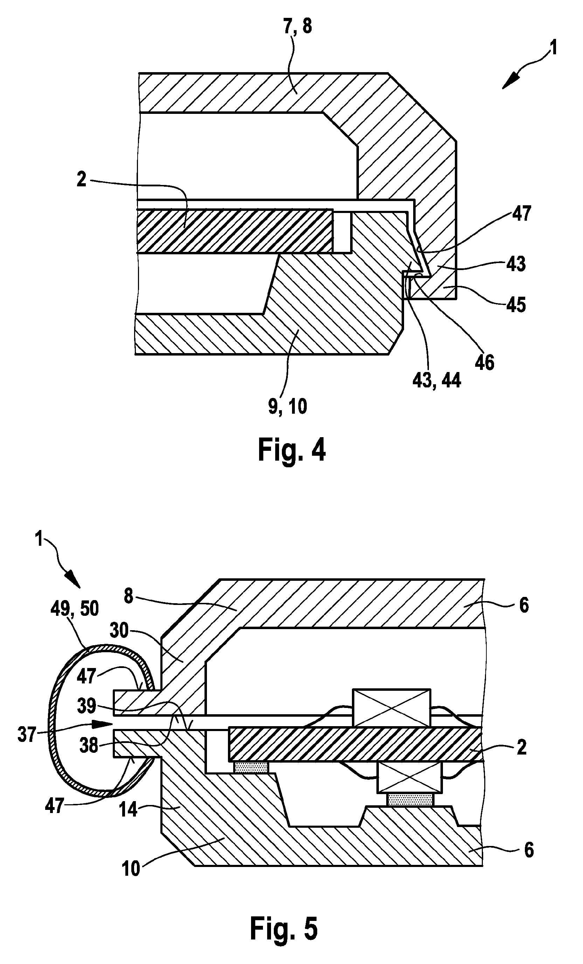

Figur 4 zeigt einen Abschnitt des Gehäuses 1 mit Deckel 7 und Boden 9 sowie eingelegtem Schaltungsträger 2. An der den Deckel 7 bildenden Deckelschale 8 und der den Boden 9 bildenden Bodenschale 10 sind miteinander verrastbare Rastelemente 43 ausgebildet, nämlich an der Bodenschale 10 in Form einer Rastnase 44 und an der Deckelschale 8 in Form eines die Rastnase 44 übergreifenden Rasthakens 45, der zum Hintergreifen der Rastnase 44 eine Rastfläche 46 im Anschluss an eine der Kontur der Rastnase 44 formangepasstem Rastausnehmung 47 aufweist. Die Rastnase 44 kann hierbei umlaufend um die Bodenschale 10 ausgebildet sein, oder auch nur abschnittsweise. Die Rasthaken 45 werden zur einfachen Handhabung bevorzugt abschnittsweise an der Deckelschale 8 ausgebildet, besonders bevorzugt auch beabstandet zueinander. Selbstverständlich sind hier sämtliche aus dem Stand der Technik bereits bekannten Ausführungen von Verrastungen denkbar, die ein ausreichendes Ineinandergreifen und Verrasten zum Zusammenhalten von Deckelschale 8 und Bodenschale 10 ermöglichen, die hier gemachten Ausführungen sind lediglich als Anhaltspunkte für vorteilhafte Ausgestaltungen anzusehen.

Figur 5 zeigt einen Abschnitt des Gehäuses 1 im Längsschnitt, nämlich die Deckelschale 8 und die Bodenschale 10 mit in das Gehäuse eingelegtem Schaltungsträger 2. Die Deckelschale 8 und die Bodenschale 10 weisen außenseitig an ihrem Bodenwandbereich 14 beziehungsweise außenseitig an ihren Deckelwandrandbereichen 30 Klemmflächen 47 auf, die als umlaufende Konturen oder als abschnittweise umlaufende Konturen ausgebildet sind, die also beispielsweise in Form von Zungen 48 über die Gehäuseschalen 6 außenumfangsseitig im Bereich des Bodenwandrandbereichs 14 respektive des Deckelwandbereichs 30 hervorstehen. Die Klemmflächen sind hierbei jeweils an den außenseitig oberen beziehungsweise unteren Bereichen der Zungen 48 ausgebildet. Sie dienen dem Aufbringen von Federelementen 49, die beispielsweise als Ringklemmfedern 50 ausgebildet sein können. Durch die Federelemente 49 werden die Klemmflächen 47 an den Gehäuseschalen 6 kraftbeaufschlagt und drücken die Deckelwandstirnfläche 38 und die Bodenwandstirnfläche 39 zusammen, so dass die Gehäusehalbschalen zum Gehäuse 1 geschlossen werden. Selbstverständlich ist auch hier in dem Fügebereich zwischen Deckelwandstirnfläche 38 und Bodenwandstirnfläche 39 das Einbringen einer hier nicht dargestellten Dichtung möglich.

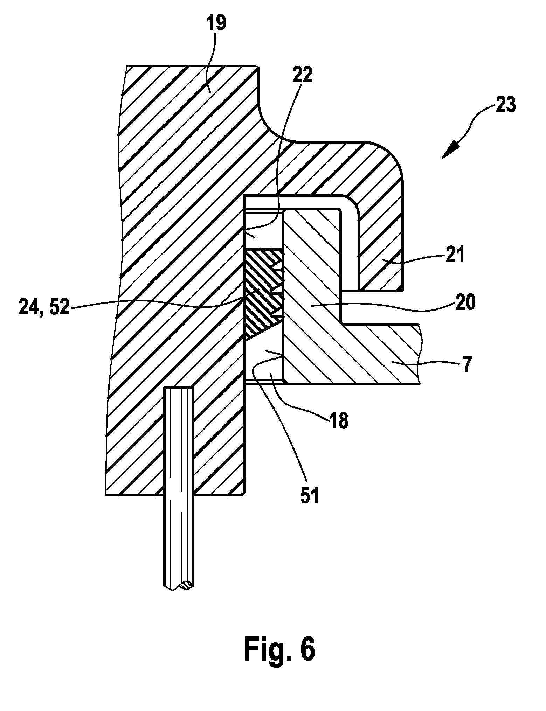

Figur 6 zeigt im Längsschnitt einen Abschnitt des Durchbruchs 18 durch den Deckel 7 bei eingestecktem Anschlussstecker 19. Wie bereits zuvor in Figur 1 beschrieben, ist der Anschlussstecker 19 mit einer den am Deckel 7 ausgebildeten, den Durchbruch 18 berandeten Stehkragen 20 übergreifenden, den Anschlussstecker 19 umlaufenden Tülle 21 versehen, die zusammen mit dem Stehkragen 20 und der Anschlusssteckeraußenfläche 22 eine Labyrinthdichtung 23 ausbildet. Zwischen der Anschlusssteckeraußenfläche 22 und einer Stehkrageninnenfläche 51, also der Fläche des Stehkragens, die dem Anschlussstecker 19 zugewandt ist und die innere Umgrenzung des Durchbruchs 18 ausbildet, ist eine den Anschlussstecker 19 im Bereich der Anschlusssteckeraußenfläche 22 umlaufende Abdichtung 24 eingebracht, die dem Durchbruch 18 zugeordnet ist. Die Abdichtung 24 ist als eine an dem Anschlussstecker 19 angebrachte, beispielsweise umlaufend um diesen verklebte, Lamellendichtung 52 ausgebildet. Zwar bietet eine Labyrinthdichtung 23 bereits weitgehenden Schutz gegen Umwelteinflüsse, insbesondere gegen gröbere Partikel und, bei hinreichend dichtem Sitz, auch gegen Feuchtigkeit; durch Einbringen der Abdichtung 24, insbesondere in Form der Lamellendichtung 52 lässt sich aber eine weitergehende, sehr gute Dichthaltung bei eingestecktem Anschlussstecker 19 erreichen.

## Patentansprüche

1. Gehäuse für eine elektrische Schaltung, insbesondere eines Steuergeräts eines Fahrzeugs, insbesondere Kraftfahrzeugs, mit einem Boden, einem Deckel und einer elektrischen Anschlussschnittstelle, wobei der Boden (9) als Bodenschale (10) und der Deckel (7) als Deckelschale (8) ausgebildet sind, wobei der Boden (9) und/oder der Deckel (7) eine integrierte Schaltungsträgeraufnahme (16) für einen elektrischen Schaltungsträger (2) aufweist und wobei der Boden (9) und/oder der Deckel (7) mindestens einen Durchbruch (18) für die Anschlussschnittstelle (25) aufweist, **dadurch gekennzeichnet, dass** die Anschlussschnittstelle (26) als eine lösbare Anschlussschnittstelle (26) ausgebildet ist.

2. Gehäuse nach Anspruch 1, **dadurch gekennzeichnet, dass** der Durchbruch (18) in einer Deckenwandung der Deckelschale (8) und/oder in einer Bodenwandung der Bodenschale (10) angeordnet ist.

3. Gehäuse nach einem der vorhergehenden Ansprüche, **dadurch gekennzeichnet, dass** der Durchbruch (18) von einem Stehkragen (20) berandet ist.

4. Gehäuse nach einem der vorhergehenden Ansprüche, **dadurch gekennzeichnet, dass** die Anschlussschnittstelle (25) elektrische Steckaufnahmen (28) (elektrische Buchsenelemente) aufweist, in die Steckstifte (27) eines Anschlusssteckers (19) einsteckbar sind.

5. Gehäuse nach einem der vorhergehenden Ansprüche, **dadurch gekennzeichnet, dass** die elektrischen Steckaufnahmen (28) an dem Schaltungsträger (2) angeordnet oder dort ausgebildet sind.

6. Gehäuse nach einem der vorhergehenden Ansprüche, **dadurch gekennzeichnet, dass** die elektrischen Steckaufnahmen (28) Anschlussdurchbrüche (29) in dem Schaltungsträger (2) aufweisen.

7. Gehäuse nach einem der vorhergehenden Ansprüche, **dadurch gekennzeichnet, dass** die Deckelschale (8) und/oder die Bodenschale (10) Kühlkontaktflächen (34) zum Berührungskontaktieren von dem Schaltungsträger (2) zugeordneten elektrischen/elektronischen Bauteilen (35) aufweist.

8. Gehäuse nach einem der vorhergehenden Ansprüche, **dadurch gekennzeichnet, dass** die Deckelschale (8) und/oder die Bodenschale (10) mit mindestens einem integrierten Schaltungsträgerniederhalter (31) ausgebildet ist/sind.

9. Gehäuse nach einem der vorhergehenden Ansprüche, **dadurch gekennzeichnet, dass** Deckelschale (8) und Bodenschale (10) miteinander verrastbare Rastelemente (43) aufweisen.

10. Gehäuse nach einem der vorhergehenden Ansprüche, **dadurch gekennzeichnet, dass** Deckelschale (8) und Bodenschale (10) Klemmflächen (47) für dem Verklemmen der beiden Schalen (5) dienende Federelemente (49) aufweist.

11. Gehäuse nach einem der vorhergehenden Ansprüche, **dadurch gekennzeichnet, dass** zwischen Deckelschale (8) und Bodenschale (10) mindestens eine Dichtung (40) angeordnet ist.

12. Gehäuse nach einem der vorhergehenden Ansprüche, **dadurch gekennzeichnet, dass** dem Durchbruch (18) eine Abdichtung (24) zugeordnet ist.

## Claims

1. Housing for an electrical circuit, in particular of a control device of a vehicle, in particular of a motor vehicle, having a base, a cover and an electrical connection interface, wherein the base (9) is in the form of a base shell (10) and the cover (7) is in the form of a cover shell (8), wherein the base (9) and/or the cover (7) have/has an integrated circuit mount receptacle (16) for an electrical circuit mount (2), and wherein the base (9) and/or the cover (7) have/has at least one aperture (18) for the connection interface (25), **characterized in that** the connection interface (26) is in the form of a detachable connection interface (26).

2. Housing according to Claim 1, **characterized in that** the aperture (18) is arranged in a ceiling wall of the cover shell (8) and/or in a base wall of the base shell (10).

3. Housing according to either of the preceding claims, **characterized in that** the aperture (18) is bordered by a projecting collar (20).

4. Housing according to one of the preceding claims, **characterized in that** the connection interface (25) has electrical plug receptacles (28) (electrical socket elements) into which plug pins (27) of a connection plug (19) can be inserted.

5. Housing according to one of the preceding claims, **characterized in that** the electrical plug receptacles (28) are arranged on the circuit mount (2) or are formed on the said circuit mount.

6. Housing according to one of the preceding claims, **characterized in that** the electrical plug receptacles (28) have connection apertures (29) in the circuit mount (2).

7. Housing according to one of the preceding claims, **characterized in that** the cover shell (8) and/or the base shell (10) have/has cooling contact areas (34) with which physical contact is made by electrical/electronic components (35) which are associated with the circuit mount (2).

8. Housing according to one of the preceding claims, **characterized in that** the cover shell (8) and/or the base shell (10) are/is formed with at least one integrated circuit mount holding-down means (31).

9. Housing according to one of the preceding claims, **characterized in that** the cover shell (8) and the base shell (10) have latching elements (43) which can be latched to one another.

10. Housing according to one of the preceding claims, **characterized in that** the cover shell (8) and the base shell (10) have clamping areas (47) for spring elements (49) which serve to clamp the two shells (5).

11. Housing according to one of the preceding claims, **characterized in that** at least one seal (40) is arranged between the cover shell (8) and the base shell (10).

12. Housing according to one of the preceding claims, **characterized in that** a sealing-off means (24) is associated with the aperture (18).

## Revendications

1. Boîtier pour un circuit électrique, notamment d'un appareil de commande d'un véhicule, en particulier d'un véhicule automobile, comprenant un fond, un couvercle et une interface de raccordement électrique, le fond (9) étant réalisé sous forme de coque de fond (10) et le couvercle (7) étant réalisé sous forme de coque de couvercle (8), le fond (9) et/ou le couvercle (7) présentant un logement de support de circuit intégré (16) pour un support de circuit électrique (2) et le fond (9) et/ou le couvercle (7) présentant au moins un orifice (18) pour l'interface de raccordement (25), **caractérisé en ce que** l'interface de raccordement (26) est réalisée sous forme d'interface de raccordement détachable (26).

2. Boîtier selon la revendication 1, **caractérisé en ce que** l'orifice (18) est disposé dans une paroi de plafond de la coque de couvercle (8) et/ou dans une paroi de fond de la coque de fond (10).

3. Boîtier selon l'une quelconque des revendications précédentes, **caractérisé en ce que** l'orifice (18) est bordé par un rebord montant (20).

4. Boîtier selon l'une quelconque des revendications précédentes, **caractérisé en ce que** l'interface de raccordement (25) présente des logements pour fiches électriques (28) (éléments de douille électrique) dans lesquels peuvent être enfichées des fiches (27) d'un connecteur (19).

5. Boîtier selon l'une quelconque des revendications précédentes, **caractérisé en ce que** les logements pour fiches électriques (28) sont disposés ou réalisés sur le support de circuit (2).

6. Boîtier selon l'une quelconque des revendications précédentes, **caractérisé en ce que** les logements pour fiches électriques (28) présentent des orifices de raccordement (29) dans le support de circuit (2).

7. Boîtier selon l'une quelconque des revendications précédentes, **caractérisé en ce que** la coque de couvercle (8) et/ou la coque de fond (10) présentent des surfaces de contact de refroidissement (34) pour le contact physique de composants électriques/électroniques (35) associés au support de circuit (2).

8. Boîtier selon l'une quelconque des revendications précédentes, **caractérisé en ce que** la coque de couvercle (8) et/ou la coque de fond (10) est/sont réalisée(s) avec au moins un dispositif de retenue de support de circuit intégré (31).

9. Boîtier selon l'une quelconque des revendications précédentes, **caractérisé en ce que** la coque de couvercle (8) et la coque de fond (10) présentent des éléments d'encliquetage (43) pouvant être encliquetés les uns aux autres.

10. Boîtier selon l'une quelconque des revendications précédentes, **caractérisé en ce que** la coque de couvercle (8) et la coque de fond (10) présentent des surfaces de serrage (47) pour des éléments de ressort (49) pour serrer les deux coques (5).

11. Boîtier selon l'une quelconque des revendications précédentes, **caractérisé en ce qu'**entre la coque de couvercle (8) et la coque de fond (10) est disposé au moins un joint d'étanchéité (40).

12. Boîtier selon l'une quelconque des revendications précédentes, **caractérisé en ce que** l'orifice (18) est associé à une garniture d'étanchéité (24).
